# EUROPÄISCHE PATENTSCHRIFT

(11) **EP 0 453 953 B1**
(45) Veröffentlichungstag und Bekanntmachung des Hinweises auf die Patenterteilung: **24.09.1997**
(21) Anmeldenummer: 91106188.5
(22) Anmeldetag: 18.04.1991
(51) Int. Cl.: G03F 7/20, G03F 7/029

(54) **Verfahren zur Herstellung von Druckformen oder Photoresists durch bildmässiges Bestrahlen eines photopolymerisierbaren Aufzeichnungsmaterials**
Process for the production of printing plates or photoresist by imagewise exposure of a photopolymerisable registration material
Procédé pour la fabrication de plaques d'impression ou photoréserves par exposition selon une image d'une couche d'enregistrement photopolymérisable

(30) Priorität: 26.04.1990 DE 4013358
(43) Veröffentlichungstag der Anmeldung: 30.10.1991
(73) Patentinhaber: Agfa-Gevaert AG, 51373 Leverkusen (DE)
(72) Erfinder: Zertani, Rudolf, Dr., W-6500 Mainz 43 (DE); Mohr, Dieter, Dr., W-6501 Budenheim (DE); Matthiessen, Peter, W-6204 Taunusstein-Wehen (DE)

(56) Entgegenhaltungen:
- EP-A- 0 364 735
- US-A- 3 784 378

## Beschreibung

Die Erfindung betrifft ein Verfahren zur Herstellung von Druckformen oder Photoresists durch bildmäßiges Bestrahlen eines photopolymerisierbaren Aufzeichnungsmaterials, das ein polymeres Bindemittel, eine radikalisch polymerisierbare Verbindung, insbesondere einen Acryl- oder Alkacrylsäureester, sowie einen Photoinitiator oder eine Photoinitiatorkombination enthält.

Aus der DE-B 12 14 085 (US-A 3 144 331) ist es bekannt, zur Wiederherstellung der Empfindlichkeit photopolymerisierbarer Aufzeichnungsmaterialien, die aus einem plattenträger und einer lichtempfindlichen Schicht bestehen und deren Empfindlichkeit durch Absorption von molekularem Sauerstoff nachgelassen hat, die lichtempfindliche Schicht mit 70 bis 98 % der Strahlungsmenge an aktinischer Strahlung zu belichten, die zur Einleitung der Photopolymerisation notwendig wäre. Die Belichtung erfolgt beispielsweise durch den transparenten Druckplattenträger hindurch, wobei aktinische Strahlung mit einer solchen Wellenlänge verwendet wird, daß nur 10 bis 70 % der Strahlung von der photopolymerisierbaren Schicht absorbiert werden. Bei diesem Verfahren wird im Prinzip einmal diffus und einmal bildmäßig belichtet. An die Diffus- bzw. Vorbelichtung schließt dann die bildmäßige Belichtung bis zur vollen Strahlungsmenge an.

Aus der US-A 4 716 097 ist ein Verfahren bekannt, bei dem eine photopolymerisierbare Schicht, die einen Farbstoff enthält, zuerst mit Licht einer Wellenlänge oberhalb von 400 nm und einer Intensität von mindestens 1500 Lumen/m² ca. 60 Minuten diffus und danach bildmäßig belichtet wird.

In der DE-A 24 12 571 ist ein Verfahren zum Aushärten einer durch Licht härtbaren Schicht einer Druckplatte beschrieben, bei dem zuerst diffus für kurze Zeit und danach bildmäßig so lange belichtet wird, bis die Schicht in den belichteten Bereichen praktisch vollständig ausgehärtet ist. Die diffuse Belichtung dauert maximal 90 % der Zeit, die zur Aushärtung der Polymerschicht bei gleicher Intensität der Strahlung sowohl für die Vorbelichtung als auch für die bildmäßige Belichtung erforderlich ist.

In der EP-A 53 708 wird ein Verfahren zur Herstellung von Reliefkopien beschrieben, bei dem die photopolymerisierbare Schicht eines Aufzeichnungsmaterials bildmäßig belichtet, vor oder nach dem Belichten kurze Zeit auf erhöhte Temperaturen erwärmt und dann entwickelt wird.

In der EP-A 284 938 werden photopolymerisierbare Gemische beschrieben, die (Meth)acrylsäureester mit Urethangruppen, tertiären Aminogruppen und ggf. Harnstoffgruppen im Molekül, polymere Bindemittel und als Photoinitiator einen photoreduzierbaren Farbstoff, ggf. kombiniert mit einer strahlungsempfindlichen Trihalogenmethylverbindung, enthalten. In der EP-A 321 827 werden ähnliche Gemische mit (Meth(acrylsäureestern beschrieben, die keine Urethangruppen enthalten.

In der EP-A 364 735 werden photopolymerisierbare Gemische beschrieben, die
- ein polymeres Bindemittel,
- eine radikalisch polymerisierbare Verbindung mit mindestens einer polymerisierbaren Gruppe,
- einen photoreduzierbaren Farbstoff,
- eine durch Strahlung spaltbare Trihalogenmethylverbindung und
- eine Metallocenverbindung, insbesondere ein Titanocen oder Zirkonocen,
enthalten. Als Metallocene werden solche eingesetzt, die als Liganden zwei ggf. substituierte Cyclopentadienylreste und zwei substituierte Phenylreste tragen. In der nicht vorveröffentlichten älteren deutschen Patentanmeldung P 40 07 428.5 werden photopolymerisierbare Gemische der vorstehenden Zusammensetzung beschrieben, die als Metallocen ein Dicyclopentadienyl-bis-2,4,6-trifluor-phenyl-titan oder -zirkon enthalten. Diese Gemische weisen eine außerordentlich hohe Lichtempfindlichkeit auf.

In der nicht vorveröffentlichten älteren deutschen Patentanmeldung P 40 11 023.0 wird ein Nachbehandlungsgerät für bildmäßig belichtete Druckplatten beschrieben, das eine Belichtungsstation zur ganzflächigen Belichtung der Druckplatte und eine Erwärmungsstation enthält. Die ganzflächige Belichtung erfolgt mit Licht im Spektralbereich von 500 bis 700 nm. Es werden photopolymerisierbare Druckplatten verarbeitet, über deren Zusammensetzung keine näheren Angaben gemacht werden.

Aufgabe der Erfindung war es, ein Verfahren zur Herstellung von Druckformen, insbesondere Flachdruckformen, oder Photoresists durch bildmäßiges Belichten eines photopolymerisierbaren Aufzeichnungsmaterials, das bereits eine sehr hohe Lichtempfindlichkeit aufweist, und geeignete Weiterverarbeitungsschritte vorzuschlagen, durch das sich der Energiebedarf bei der Bildbelichtung noch wesentlich herabsetzen läßt, so daß eine entsprechend erhöhte praktische Lichtempfindlichkeit erzielt wird.

Erfindungsgemäß wird ein Verfahren zur Herstellung von Druckformen oder Photoresists durch bildmäßiges Bestrahlen eines photopolymerisierbaren Aufzeichnungsmaterials vorgeschlagen, dessen photopolymerisierbare Schicht ein polymeres Bindemittel, eine radikalisch polymerisierbare ethylenisch ungesättigte Verbindung mit mindestens einer endständigen ethylenischen Doppelbindung und einen bei Bestrahlung freie Radikale bildenden Polymerisationsinitiator bzw. eine Initiatorkombination enthält, wobei das Material nach der bildmäßigen Bestrahlung kurzzeitig erwärmt und dann entwickelt wird.

Das erfindungsgemäße Verfahren ist dadurch gekennzeichnet, daß man als Radikale bildenden Polymerisationsinitiator eine Metallocenverbindung einsetzt und daß man das Material vor, zugleich mit oder nach der bildmäßigen Bestrahlung kurzzeitig mit sichtbarem Licht einer Wellenlänge von mindestens 400 nm ohne Vorlage belichtet.

Das Erwärmen und vorlagenlose Belichten kann zweckmäßig in einer Vorrichtung erfolgen, wie sie in der älteren Anmeldung P 40 11 023.0 beschrieben ist. Die Reihenfolge der Belichtungsschritte ist beliebig, bevorzugt wird das Material zuerst bildmäßig belichtet bzw. bestrahlt, dann ohne Vorlage belichtet und schließlich erwärmt.

Die bildmäßige Bestrahlung kann vorzugsweise durch Projektion mit normalem Kopierlicht oder mit Laserstrahlung erfolgen. Als Projektionslichtquellen können z. B. Quecksilberdampflampen, Xenonlampen, Metallhalogenidlampen, Blitzlichtlampen, Kohlenbogenlampen und dgl. eingesetzt werden, wobei die Intensität und bzw. oder Dauer der Belichtung niedrig gehalten werden kann. Als Laserlichtquellen sind vor allem im sichtbaren Spektralbereich, z. B. bei 488 und 514 nm, emittierende Laser geeignet. Hier können mit Vorteil z. B. Argon-Ionen-Laser mit relativ geringer Leistung, z. B. 10 bis 25 mW, eingesetzt werden. Die Dosis der bildmäßigen Bestrahlung liegt vorzugsweise im Bereich von 5 bis 50 % der Dosis, die zur vollständigen Aushärtung der Schicht ohne weitere Behandlung erforderlich ist. Der Rest der erforderlichen Energiemenge wird erfindungsgemäß durch die Kombination von diffuser, d. h. vorlagenfreier Belichtung und Nacherwärmen zugeführt.

Zur Belichtung ohne Vorlage wird eine Lichtquelle relativ geringer Leistung, z. B. eine Leuchtstofflampe, eingesetzt, die einen möglichst hohen Anteil an Licht einer Wellenlänge oberhalb 500 nm emittiert. Der Emissionsbereich liegt im allgemeinen zwischen 400 und 700, bevorzugt zwischen 450 und 650 nm. Die Schichtoberfläche sollte im allgemeinen einer Intensität von etwa 10 bis 80 Lux ausgesetzt werden. Die Dosis muß so gewählt werden, daß sie an den zu härtenden Bildstellen zusammen mit der Bildbelichtung und der Wärmebehandlung eine vollständige Aushärtung bewirkt. Dabei ist zu beachten, daß die Nichtbildstellen durch die Diffusbelichtung in Kombination mit dem Erwärmen noch nicht so stark gehärtet werden, daß sie im Entwickler nicht mehr vollständig löslich sind. Die gewünschte Bilddifferenzierung läßt sich bei einer Bildbelichtung bzw. -bestrahlung in dem oben angegebenen Bereich von 5 bis 50 % der erforderlichen Strahlungsmenge erreichen.

Das Erwärmen erfolgt als letzte Behandlungsstufe vor dem Entwickeln in an sich bekannter Weise. Dabei wird das fertig belichtete Material etwa 10 Sekunden bis 2 Minuten auf eine Temperatur im Bereich von 60 bis 140, bevorzugt 80 bis 120 °C, insbesondere 90 bis 110 °C, erwärmt. In den meisten Fällen liegt die erforderliche Behandlungszeit im Bereich zwischen 30 und 80 Sekunden. Dabei ist die Temperatur beim Erwärmen von Druckplatten auf Schichtträgern aus Metallen, insbesondere Aluminium, zweckmäßig auf der Rückseite der Platte, z B. mit handelsüblichen Temperatur-Teststreifen, zu messen. Das Erwärmen kann durch Luftzirkulation, im Kontakt oder durch Infrarotstrahlung erfolgen.

Es wurde überraschend gefunden, daß das erfindungsgemäße Verfahren nur bei ganz bestimmten photopolymerisierbaren Materialien zu der gewünschten Empfindlichkeitssteigerung führt. So zeigte sich, daß eine entsprechende Nachbelichtung und Nacherwärmung praktisch keine Empfindlichkeitssteigerung bewirkt, wenn man ein bekanntes topolymerisierbares Material einsetzt, das als initiator 9-Phenyl-acridin und als Monomeres lolethantriacrylat enthält. Wenn man dagegen als Photoinitiator ein Metallocen, insbesondere ein Titanocen oder Zirkonocen einsetzt, wird bei gleicher Behandlung eine Steigerung der Lichtempfindlichkeit um mehrere Stufen erreicht.

Die als Initiatoren eingesetzten Metallocene sind als solche und auch als Photoinitiatoren bekannt, z. B. aus den US-A 3 717 558, 4 590 287 und 4 707 432. Bevorzugt werden Metallocene von Elementen der IV. Nebengruppe des Periodensystems, insbesondere Verbindungen des Titans und Zirkons. Derartige Verbindungen sind in der EP-A 364 735, beschrieben. Von den zahlreichen bekannten Metallocenen, insbesondere Titanocenen, werden Verbindungen der allgemeinen Formel 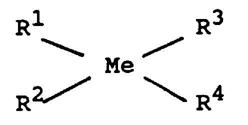 bevorzugt. In dieser Formel bedeuten
- Me: ein vierbindiges Metallatom, insbesondere Ti oder Zr,
- R¹ und R²: gleiche oder verschiedene Cyclopentadienylreste, die substituiert sein können, und
- R³ und R⁴: gleiche oder verschiedene Phenylreste, die auch substituiert sein können.

Die Cyclopentadienylgruppen können insbesondere durch Alkylreste mit 1 bis 4 Kohlenstoffatomen, Chloratome, Phenyl- oder Cyclohexylreste substituiert oder durch Alkylengruppen miteinander verknüpft sein. Sie sind bevorzugt unsubstituiert oder durch Alkylreste oder Chloratome substituiert.

R³ und R⁴ sind bevorzugt Phenylgruppen, die in o-Stellung zur Bindung mindestens ein Fluoratom enthalten und im übrigen durch Halogenatome, wie F, Cl oder Br, Alkyl- oder Alkoxygruppen mit 1 bis 4 Kohlenstoffatomen, eine ggf. veretherte oder veresterte Polyoxyalkylengruppe oder eine heterocyclische Gruppe, z. B. einen Pyrrolylrest, substituiert sein können. Die Polyoxyalkylengruppe hat im allgemeinen 1 bis 6 Oxyalkyleneinheiten und steht bevorzugt in 4-Stellung des Phenylrests und kann durch einen Alkyl- oder Acylrest mit 1 bis 18 Kohlenstoffatomen verethert bzw. verestert sein; sie ist insbesondere eine Polyoxyethylengruppe.

Der Mengenanteil an Metallocenverbindung liegt im allgemeinen zwischen 0,01 und 10, vorzugsweise bei 0,05 bis 8 Gew.-%, bezogen auf die photopolymerisierbare Schicht.

Die photopolymerisierbare Schicht kann als weiteren toinitiatorbestandteil einen photoreduzierbaren Farbstoff enthalten. Geeignete Farbstoffe sind insbesondere Xanthen-, Benzoxanthen-, Benzothioxanthen-, Thiazin-, Pyronin, Porphyrin- oder Acridinfarbstoffe.

Geeignete Xanthen- und Thiazinfarbstoffe sind z.B. in der EP-A 287 817 beschrieben. Geeignete Benzoxanthen- und Benzothioxanthenfarbstoffe sind in der DE-A 20 25 291 und der EP-A 321 828 beschrieben.

Als Porphyrinfarbstoff ist z.B. Hämatoporphyrin und als Acridinfarbstoff z.B. Acriflaviniumchlorid-Hydrochlorid geeignet.

Beispiele für Xanthenfarbstoffe sind Eosin B (C.I. Nr. 45400), Eosin J (C.I. Nr. 45380), Eosin alkohollöslich (C.I. 45386), Cyanosin (C.I. Nr.45410), Bengalrosa, Erythrosin (C.I. Nr. 45430), 2,3,7-Trihydroxy-9-phenyl-xanthen-6-on und Rhodamin 6 G (C.I. Nr. 45160).

Beispiele für Thiazinfarbstoffe sind Thionin (C.I. Nr. 52000), Azur A (C.I. Nr. 52005) und Azur C (C.I. Nr.52002).

Beispiele für Pyroninfarbstoffe sind Pyronin B (C.I. Nr. 45010) und Pyronin GY (C.I. Nr. 45005). Die Menge des photoreduzierbaren Farbstoffs liegt im allgemeinen zwischen 0,01 und 10, vorzugsweise zwischen 0,05 und 4 Gew.-% der Schicht.

Zur Steigerung der Lichtempfindlichkeit können die photopolymerisierbaren Schichten noch Verbindungen mit photolytisch spaltbaren Trihalogenmethylgruppen enthalten, die als radikalbildende Photoinitiatoren für polymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137452, der DE-A 2 718 259 und der DE-A 2 243 621 beschrieben sind. Auch Verbindungen mit anderem Grundgerüst, die im kürzerwelligen UV-Bereich absorbieren, z. B. Phenyltrihalogenmethylsulfone oder Phenyltrihalogenmethylketone, z.B. das Phenyltribrommethylsulfon, sind geeignet. Die Halogenverbindungen werden im allgemeinen in einer Menge von 0,01 bis 10, vorzugsweise von 0,05 bis 4 Gew.-% der Schicht eingesetzt.

Die photopolymerisierbaren Schichten können ggf. noch weitere Initiatorbestandteile, z. B. Acridin-, Phenazin- oder Chinoxalinverbindungen, enthalten. Diese Verbindungen sind als Photoinitiatoren bekannt und in den DE-C 2027467 und 2039861 beschrieben. Die Gesamtmenge an lymerisationsinitiatoren liegt im allgemeinen bei 0,05 bis 20, vorzugsweise bei 0,1 bis 10 Gew.-%.

Für die Zwecke der Erfindung geeignete polymerisierbare Verbindungen sind bekannt und z.B. in den US-A 2760863 und 3060023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Besonders bevorzugt werden polymerisierbare Verbindungen, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile heterocyclischer Ringe sein können, Enolgruppen und Carboxylgruppen in Kombination mit olefinischen Doppelbindungen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel I 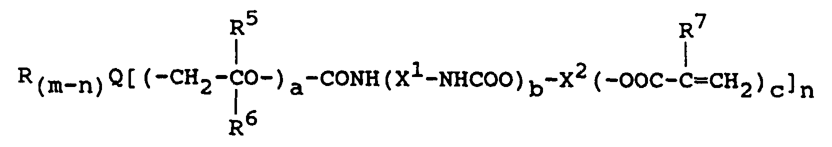 worin
- Q: 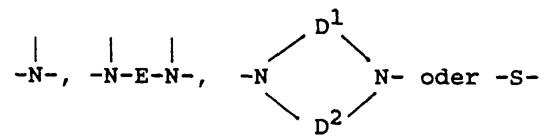
- R: eine Alkyl-, Hydroxyalkyl- oder Arylgruppe,
- R⁵ und R⁶: jeweils ein Wasserstoffatom, eine Alkylgruppe oder Alkoxyalkylgruppe,
- R⁷: ein Wasserstoffatom, eine Methyl- oder Ethylgruppe,
- X¹: eine gesättigte Kohlenwasserstoffgruppe mit 2 bis 12 Kohlenstoffatomen,
- X²: eine (c+1)-wertige gesättigte wasserstoffgruppe, in der bis zu 5 Methylengruppen durch Sauerstoffatome ersetzt sein können,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,
- a: 0 oder eine Zahl von 1 bis 4,
- b: 0 oder 1,
- c: eine ganze Zahl von 1 bis 3,
- m: je nach Wertigkeit von Q 2, 3 oder 4 und
- n: eine ganze Zahl von 1 bis m
bedeutet, wobei alle Symbole gleicher Definition untereinander gleich oder verschieden sein können. Die Verbindungen dieser Formel, ihre Herstellung und Verwendung sind ausführlich in der EP-A 287 818 beschrieben. Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein. Verbindungen, in denen alle Substituenten von Q polymerisierbare Reste sind, d.h. in denen m = n ist, werden im allgemeinen bevorzugt. Im allgemeinen ist in nicht mehr als einem, bevorzugt in keinem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn R⁵ und R⁶ Alkyl- oder Alkoxyalkylgruppen sind, können diese 1 bis 5 Kohlenstoffatome enthalten. R⁷ ist bevorzugt ein Wasserstoffatom oder eine Methylgruppe, besondere eine Methylgruppe.

X¹ ist bevorzugt ein geradkettiger oder verzweigter aliphatischer oder cycloaliphatischer Rest mit vorzugsweise 4 bis 10 Kohlenstoffatomen. X² hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. X² kann auch eine cycloaliphatische Gruppe mit 5 bis 10 Kohlenstoffatomen, insbesondere eine Cyclohexylengruppe sein. D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt. Der Wert von c ist vorzugsweise 1.

Weitere geeignete Verbindungen mit photooxydierbaren Gruppen sind Verbindungen der Formel II 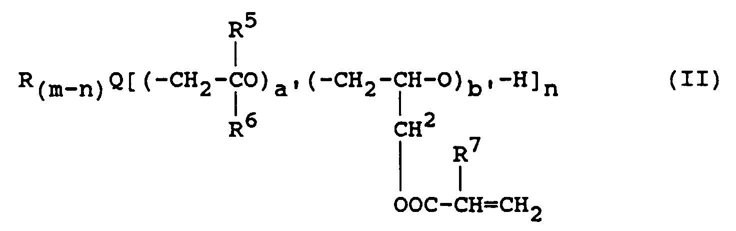 worin Q, R, R⁵, R⁶, R⁷, m und n die oben angegebene Bedeutung haben und Q zusätzlich eine Gruppe 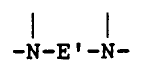 sein kann, worin E' eine Gruppe der Formel III 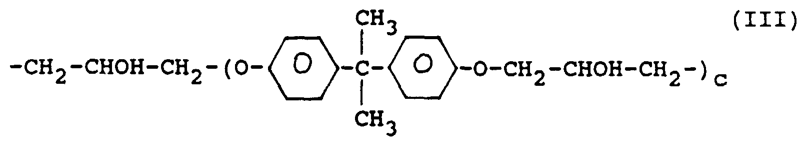 ist, in der c die Bedeutung wie in Formel I hat; a' und b' sind ganze Zahlen von 1 bis 4.

Die Verbindungen dieser Formel, ihre Herstellung und Verwendung sind ausführlich in der EP-A 316 706 beschrieben.

Weitere geeignete Verbindungen mit photooxydierbaren Gruppen sind Acryl- und Alkacrylsäureester der Formel IV 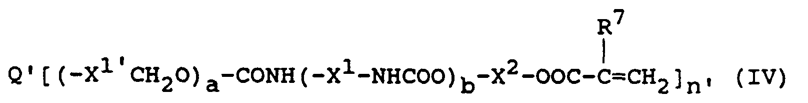 worin
- Q': 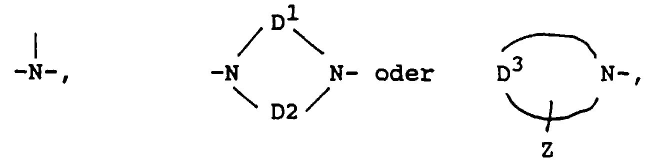
- X^{1'}: CᵢH₂ᵢ oder 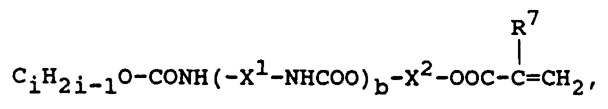
- D³: eine gesättigte Kohlenwasserstoffgruppe mit 4 bis 8 Kohlenstoffatomen, die mit dem Stickstoffatom einen 5- oder 6-gliedrigen Ring bildet,
- Z: ein Wasserstoffatom oder einen Rest der Formel 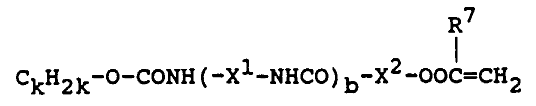
- i und k: ganze Zahlen von 1 bis 12,
- n': je nach Wertigkeit von Q' 1, 2 oder 3
bedeutet, und R⁷, X¹, X², D¹, D², a und b die bei Formel I angegebene Bedeutung haben, wobei alle Symbole gleicher Definition untereinander gleich oder verschieden sein können und wobei in mindestens einem Substituenten an der Gruppe Q a = O ist.

Von den Verbindungen der Formel IV werden solche bevorzugt, die außer einer Harnstoffgruppe mindestens eine Urethangruppe enthalten.

Das Symbol a ist in Formel IV vorzugsweise 0 oder 1; i ist vorzugsweise eine Zahl von 2 bis 10.

Die polymerisierbaren Verbindungen der Formel IV werden analog zu den Verbindungen der Formel I hergestellt. Die Verbindungen der Formel IV und ihre Herstellung sind ausführlich in der EP-A 355 387 beschrieben.

Der Mengenanteil der photopolymerisierbaren Schicht an polymerisierbaren Verbindungen beträgt im allgemeinen etwa 10 bis 80, bevorzugt 20 bis 60 Gew.-%, bezogen auf die nichtflüchtigen Bestandteile.

Beispiele für verwendbare Bindemittel sind chloriertes Polyethylen, chloriertes Polypropylen, Poly(meth)acrylsäurealkylester, bei denen die Alkylgruppe z.B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/Acrylnitril-Copolymere, Polyvinylidenchlorid, Vinylidenchlorid/Acrylnitril-Copolymere, Polyvinylacetat, vinylalkohol, Polyacrylnitril, Acrylnitril/Styrol-Copolymere, Acrylnitril/Butadien/Styrol-Copolymere, Polystyrol, Polymethylstyrol, Polyamide (z.B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wässrig alkalischen Lösungen löslich oder zumindest quellbar sind.

Besonders erwähnt werden sollen Carboxylgruppen enthaltende Bindemittel, z.B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin geeignet sind Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen nylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200000 oder darüber, bevorzugt 1000 bis 100000 aufweisen und entweder Säurezahlen zwischen 10 und 250, bevorzugt von 20 bis 200, oder Hydroxylzahlen zwischen 50 und 750, bevorzugt von 100 bis 500, aufweisen. Die Menge des Bindemittels in der lichtempfindlichen Schicht beträgt im allgemeinen 20 bis 90, vorzugsweise 40 bis 80 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 300 nm bis 700 nm.

Als Anwendungsmöglichkeiten für das erfindungsgemäße Verfahren seien genannt: die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter ist das Verfahren zur photomechanischen Herstellung von Ätzreservagen, z. B. für die Fertigung von Namensschildern, von kopierten Schaltungen und für das Formteilätzen, anwendbar. Besondere Bedeutung hat die Herstellung von Flachdruckplatten und die Photoresisttechnik.

Als Schichtträger sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Es ist im allgemeinen günstig, die photopolymerisierbaren Materialien während der Lichtpolymerisation dem Einfluß des Luftsauerstoffs weitgehend zu entziehen. Bei dünnen Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z.B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt.

Hierfür geeignete Stoffe sind z. B. Polyvinylalkohol, Polyphosphate, Zucker usw. Solche Deckschichten haben im allgemeinen eine Dicke von 0,1 bis 10, vorzugsweise 1 bis 5 µm.

Zur Entwicklung werden die Materialien mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiele 1-7 (Vergleichsbeispiele)

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung der folgenden Zusammensetzung setzung überzogen. Dabei wurden alle Operationen unter Rotlicht durchgeführt:

| | |
|---|---|
| 2,84 Gt | einer 22,3 %igen Lösung eines Terpolymerisats aus Styrol, n-Hexylmethacrylat und Methacrylsäure (10:60:30) mit der Säurezahl 190 in Methylethylketon, |
| 1,49 Gt | Monomeres gemäß Tabelle 1, |
| 0,04 Gt | Eosin alkohollöslich (C.I. 45386), |
| 0,03 Gt | 2,4-Bis-trichlormethyl-6-(4-styrylphenyl)-s-triazin und |
| 0,01 Gt | Dicyclopentadienyl-bis-pentafluorphenyl-titan in |
| 22 Gt | Propylenglykolmonomethylether. |

Das Auftragen erfolgte durch Aufschleudern in der Weise, daß ein Trockengewicht von 2,4 bis 2,8 g/m² erhalten wurde. Anschließend wurde die Platte zwei Minuten bei 100 °C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 2,5 bis 4 g/m² erhalten. Die erhaltene Druckplatte wurde mittels einer 2 kW-Metallhalogenidlampe im Abstand von 110 cm unter unter einem 13-stufigen Belichtungskeil mit Dichteinkrementen von 0,15 belichtet. Um die Empfindlichkeit der Druckplatten im sichtbaren Licht zu testen, wurden auf den Belichtungskeil ein 3 mm starkes Kantenfilter der Firma Schott mit der Kantendurchlässigkeit von 455 nm und ein Silberfilm mit gleichmäßiger Schwärzung (Dichte 1,4) und gleichmäßiger Absorption über den wirksamen Spektralbereich als Graufilter montiert. Die Platten wurden 10 Sekunden belichtet, und danach eine Minute auf 100 °C erwärmt. Anschließend wurden sie mit einem Entwickler folgender Zusammensetzung entwickelt:

| | |
|---|---|
| 120 Gt | Natriummetasilikat x 9 H₂O, |
| 2,13 Gt | Strontiumchlorid, |
| 1,2 Gt | nichtionogenes Netzmittel (Kokosfett- alkohol-Polyoxyethylenether mit ca. 8 Oxyethyleneinheiten) und |
| 0,12 Gt | Antischaummittel in |
| 4000 Gt | vollentsalztem Wasser. |

Die Platten wurden mit fetter Druckfarbe eingefärbt. Es wurden die in Tabelle 2 angegebenen vollvernetzten Keilstufen erhalten.

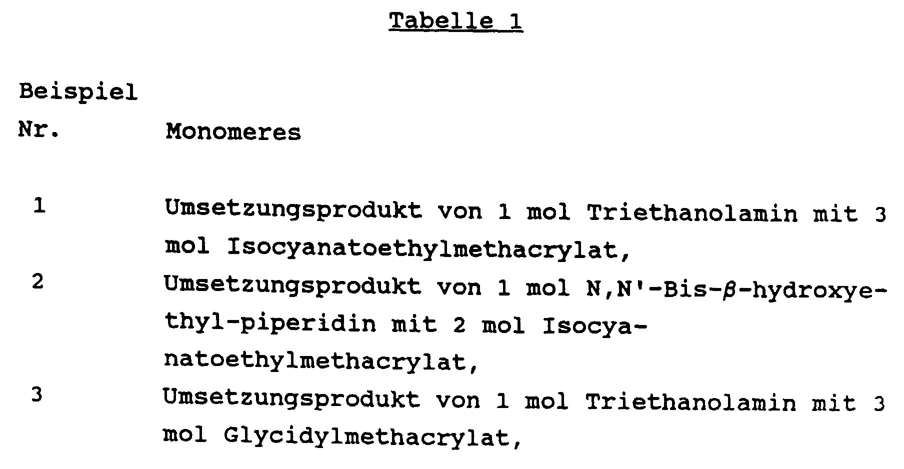

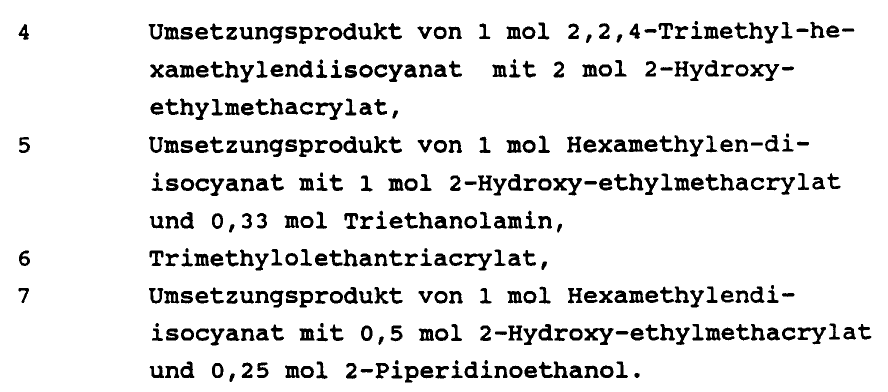

### Beispiele 8-14

Die in den Beispielen 1 bis 7 beschriebenen Druckplatten wurden wie dort hergestellt und bildmäßig belichtet. Sie wurden dann ganzflächig mit diffusem Licht aus einer Leuchtstofflampe, die Licht von etwa 400 bis 700 nm emittiert und deren Spektralanteil unterhalb 500 nm durch ein Filter absorbiert wurde, mit einer Beleuchtungsstärke von 15 Lux 20 Sekunden nachbelichtet und dann wie in den Beispielen 1 bis 7 nacherwärmt und entwickelt. Die Anzahl der erhaltenen Keilstufen ist in Tabelle 2 angegeben.

**Tabelle 2**

| Beispiel Nr. | Graufilter | Keilstufen |
|---|---|---|
| 1 | ja | 6 - 7 |
| 2 | ja | 7 |
| 3 | ja | 5 - 9 |
| 4 | ja | 4 - 5 |
| 5 | ja | 5 - 7 |
| 6 | ja | -* |
| 6 | nein | 1 - 2 |
| 7 | ja | 8 - 9 |
| 8 | ja | 9 - 11 |
| 9 | ja | 10 |
| 10 | ja | 8 - 12 |
| 11 | ja | 7 - 8 |
| 12 | ja | 8 - 10 |
| 13 | ja | 2 - 3 |
| 13 | nein | 3 - 5 |
| 14 | ja | 11 - 12 |

| | | |
|---|---|---|
| * Kein Bild | | |

### Beispiel 15

Auf den in den Beispielen 1 bis 7 angegebenen Schichtträger wurde unter gleichen Bedingungen wie dort eine Lösung folgender Zusammensetzung so aufgeschleudert, daß ein Schichtgewicht von 2,5 g/m² erhalten wurde:

| | |
|---|---|
| 2,84 Gt | der in Beispiel 1 angegebenen Terpolymerisatlösung, |
| 1,49 Gt | Monomeres wie in Beispiel 7, |
| 0,04 Gt | Eosin alkohollöslich (C.I. 45386), |
| 0,03 Gt | 2,4-Bis-trichlormethyl-6-(4-styrylphenyl)-s-triazin und |
| 0,01 Gt | Dicyclopentadienyl-bis-2,4,6-trifluorphenyltitan in |
| 22 Gt | Propylenglykolmonomethylether. |

Nach Auftragen einer Deckschicht aus Polyvinylalkohol wurde die Platte in gleicher Weise wie in den Beispielen 1 bis 7 5 Sekunden belichtet und dann entwickelt. Um die Empfindlichkeit der Druckplatte im sichtbaren Licht zu testen, wurde auf den Belichtungskeil ein 3 mm starkes Kantenfilter der Firma Schott mit der Kantendurchlässigkeit von 455 nm und ein Silberfilm mit gleichmäßiger Schwärzung (Dichte 1,1) als Graufilter montiert. Es wurden 8 bis 9 vollvernetzte Keilstufen erhalten. In einem weiteren Versuch wurde die Platte wie in den Beispielen 8 -14 angegeben diffus nachbelichtet. Es wurden 11 bis 12 vollvernetzte Keilstufen erhalten.

Die Druckplatten waren in beiden Fällen tonfrei entwikkelt und ergaben über 150 000 einwandfreie Drucke.

### Beispiel 16

Eine wie in Beispiel 7 hergestellte photopolymerisierbare Druckplatte wurde in einem handelsüblichen Filmbelichter mittels eines Argon-Ionenlasers (λ= 488 nm) mit 182 µJ/cm² bestrahlt und wie in Beispiel 7 ohne Nachbelichtung verarbeitet. Es wurden über 150 000 einwandfreie Drucke erhalten.

Eine gleiche Platte wurde nach der Laserbestrahlung mit 375 Luxsekunden wie in Beispiel 14 beschrieben nachbelichtet. Es ergab sich, daß unter diesen Bedingungen nur eine Bestrahlungsenergie von 32 µJ/cm² erforderlich war, um die Platte vollständig zu härten. Es wurden wiederum über 150 000 Drucke erhalten.

Wenn in einem weiteren Versuch eine Nachbelichtung von 500 Luxsekunden vorgenommen wurde, waren für die Laserbebilderung nur 18 µJ/cm² erforderlich.

### Beispiel 17

Die Beschichtungslösung aus Beispiel 7 wurde auf eine biaxial verstreckte 35 µm dicke Polyethylenterephthalatfolie so aufgeschleudert, daß nach dem Trocknen ein Schichtgewicht von 15 g/m² erhalten wurde. Die Schicht wurde drei Minuten bei 100 ^{o}C im Umlufttrockenschrank nachgetrocknet. Anschließend wurde die Schicht bei 115 ^{o}C mit 1,5 m/min auf einen gereinigten Träger laminiert, der aus einer Isolierstoffplatte mit 35 µm Kupferauflage bestand.

Die Schicht wurde mittels einer 2 kW-Metallhalogenidlampe (140 cm Abstand) unter einem Kantenfilter 455 nm, wie im Beispiel 1 beschrieben, mit einem Stufenkeil als Vorlage 30 Sekunden belichtet, wie in den Beispielen 1 bis 7 nachbelichtet, nacherwärmt und nach dem Abziehen der Folie mit 0,8 %iger Sodalösung in einem Sprühprozessor 20 Sekunden entwickelt. Es wurden 8 vollvernetzte Keilstufen erhalten. Die vernetzte Schicht war gegen die in der Leiterplattentechnik übliche Eisen-III-chlorid-Lösung resistent. Die Ätzfestigkeit war gut.

### Beispiel 18 (Vergleichsbeispiel)

Auf den in den Beispielen 1 bis 7 beschriebenen Schichtträger wurde die folgende Beschichtungslösung aufgebracht und getrocknet:

| | |
|---|---|
| 1,4 Gt | eines Methacrylsäure/Methylmethacrylat-Mischpolymerisats mit der Säurezahl 115, |
| 1,4 Gt | Trimethylolethantriacrylat, |
| 0,2 Gt | Di-hydroxyethoxy-hexan und |
| 0,05 Gt | 9-Phenyl-acridin in |
| 13 Gt | 2-Methoxy-ethanol |

Die Platte wurde 35 Sekunden mittels einer 5 000 -W-Metallhalogenidlampe unter einem Stufenkeil belichtet und wie in Beispiel 1 nacherwärmt. Es wurden 6 bis 7 vollvernetzte Keilstufen erhalten. In einem weiteren Versuch wurde eine gleiche Platte nur 15 Sekunden belichtet, nach der Bildbelichtung mit 300 Luxsekunden diffus nachbelichtet und dann erwärmt. Es wurde kein Bild erhalten. Wenn bei unveränderter Bildbelichtung von 35 Sekunden mit 300 Luxsekunden diffus nachbelichtet wurde, wurden ebenfalls 6 bis 7 vollvernetzte Keilstufen erhalten.

## Patentansprüche

1. Verfahren zur Herstellung von Druckformen oder Photoresists durch bildmäßiges Bestrahlen eines photopolymerisierbaren Aufzeichnungsmaterials, dessen photopolymerisierbare Schicht ein polymeres Bindemittel, eine radikalisch polymerisierbare ethylenisch ungesättigte Verbindung mit mindestens einer endständigen ethylenischen Doppelbindung und einen bei Bestrahlung freie Radikale bildenden Polymerisationsinitiator bzw. eine Initiatorkombination enthält, wobei das Material nach der bildmäßigen Bestrahlung kurzzeitig erwärmt und dann entwickelt wird, dadurch gekennzeichnet, daß man als Radikale bildenden Polymerisationsinitiator eine Metallocenverbindung einsetzt und daß man das Material vor, zugleich mit oder nach der bildmäßigen Bestrahlung kurzzeitig mit sichtbarem Licht einer Wellenlänge von mindestens 400 nm ohne Vorlage belichtet.

2. Verfahren nach Anspruch 1, dadurch gekennzeichnet, daß man das Material bildmäßig mit einer Strahlungsenergie bestrahlt, die 5 bis 50 % derjenigen Energie entspricht, die ohne vorlagenfreie Belichtung und ohne Nacherwärmen zur vollständigen Aushärtung der Schicht erforderlich ist.

3. Verfahren nach Anspruch 1, dadurch gekennzeichnet, daß man die bildmäßige Bestrahlung mit Laserlicht durchführt.

4. Verfahren nach Anspruch 1, dadurch gekennzeichnet, daß man die bildmäßige Bestrahlung durch Projektionsbelichtung mit aktinischem Licht durchführt.

5. Verfahren nach Anspruch 1, dadurch gekennzeichnet, daß man das bildmäßig bestrahlte Material auf eine Temperatur im Bereich von 60 bis 140 °C nacherwärmt.

6. Verfahren nach Anspruch 1 oder 5, dadurch gekennzeichnet, daß man das Material 10 bis 120 Sekunden nacherwärmt.

7. Verfahren nach Anspruch 1 oder 2, dadurch gekennzeichnet, daß man die Nacherwärmung und Nachbelichtung so dosiert, daß die Bildstellen vollständig ausgehärtet werden und die Nichtbildstellen im Entwickler vollständig löslich bleiben.

8. Verfahren nach Anspruch 1, dadurch gekennzeichnet, daß man das photopolymerisierbare Aufzeichnungsmaterial zuerst bildmäßig bestrahlt, dann ohne Vorlage belichtet und danach erwärmt.

9. Verfahren nach Anspruch 1, dadurch gekennzeichnet, daß man der photopolymerisierbaren Schicht einen photoreduzierbaren Farbstoff als Coinitiator zusetzt.

10. Verfahren nach Anspruch 1 oder 9, dadurch gekennzeichnet, daß die radikalisch polymerisierbare Verbindung mindestens eine photooxydierbare Gruppe enthält.

11. Verfahren nach Anspruch 9, dadurch gekennzeichnet, daß man der photopolymerisierbaren Schicht zusätzlich eine durch Strahlung spaltbare Trihalogenmethylverbindung zusetzt.

12. Verfahren nach Anspruch 1, dadurch gekennzeichnet, daß das Metallocen ein Titanocen oder Zirkonocen ist.

13. Verfahren nach Anspruch 9, dadurch gekennzeichnet, daß der photoreduzierbare Farbstoff ein Xanthen-, Thiazin-, Pyronin-, Porphyrin- oder Acridinfarbstoff ist.

## Claims

1. Process for the production of printing plates or photoresists by imagewise exposure of a photopolymerisable recording material, the photopolymerisable layer of which contains a polymeric binder, a radically polymerisable ethylenically unsaturated compound having at least one terminal ethylenic double bond, and a polymerisation initiator or a combination of initiators which on irradiation forms free radicals, the said material being briefly heated after the imagewise exposure and then developed, characterised in that a metallocene compound is used as the radical-forming polymerisation initiator and that before, at the same time as, or after the imagewise exposure, the material is briefly exposed, without an object, to visible light of a wavelength of at least 400 nm.

2. Process according to claim 1, characterised in that the material is exposed imagewise using a radiation energy which corresponds to 5 to 50% of the energy required for the complete hardening of the layer without object-free exposure and without subsequent heating.

3. Process according to claim 1, characterised in that the imagewise exposure is carried out using laser light.

4. Process according to claim 1, characterised in that the imagewise exposure is carried out by projection using actinic light.

5. Process according to claim 1, characterised in that the imagewise-exposed material is subsequently heated to a temperature in the range of from 60°C to 140°C.

6. Process according to claim 1 or 5, characterised in that the material is subsequently heated for 10 to 120 seconds.

7. Process according to claim 1 or 2, characterised in that the subsequent heating and subsequent exposure are apportioned so that the image areas are completely hardened and the non-image areas remain completely soluble in the developer.

8. Process according to claim 1, characterised in that the photopolymerisable recording material is first of all exposed imagewise, then exposed without an object and then heated.

9. Process according to claim 1, characterised in that a photoreducible dye is added as a coinitiator to the photopolymerisable layer.

10. Process according to claim 1 or 9, characterised in that the radically polymerisable compound contains at least one photooxidisable group.

11. Process according to claim 9, characterised in that a trihalomethyl compound capable of being decomposed by radiation is also added to the photopolymerisable layer.

12. Process according to claim 1, characterised in that the metallocene is a titanocene or a zirconocene.

13. Process according to claim 9, characterised in that the photoreducible dye is a xanthene, thiazine, pyronine, porphyrin or acridine dye.

## Revendications

1. Procédé pour la préparation de clichés ou de réserves photographiques en soumettant à un éclairement énergétique en forme d'image un matériau d'enregistrement photopolymérisable dont la couche photopolymérisable contient un liant polymère, un composé à insaturation éthylénique, polymérisable par voie radicalaire, contenant au moins une liaison double éthylénique terminale et un initiateur, respectivement une combinaison d'initiateur de la polymérisation formant des radicaux libres lors de l'éclairement énergétique, dans lequel on chauffe brièvement le matériau après l'éclairement énergétique en forme d'image, puis on le développe, caractérisé en ce qu'on met en oeuvre, comme initiateur de la polymérisation formant des radicaux, un composé de métallocène et en ce que, avant, simultanément à ou après l'éclairement énergétique en forme d'image, on expose le matériau pendant un bref moment à la lumière visible d'une longueur d'onde d'au moins 400 nm sans original.

2. Procédé selon la revendication 1, caractérisé en ce qu'on soumet le matériau en forme d'image à un éclairement énergétique dont l'énergie de rayonnement correspond à une valeur qui représente de 5 à 50% de l'énergie qui est requise en l'absence d'un éclairement énergétique sans original et sans chauffage ultérieur pour le durcissement complet de la couche.

3. Procédé selon la revendication 1, caractérisé en ce qu'on effectue l'éclairement énergétique en forme d'image à l'aide d'une lumière laser.

4. Procédé selon la revendication 1, caractérisé en ce qu'on effectue l'éclairement énergétique en forme d'image via une exposition par projection avec de la lumière actinique.

5. Procédé selon la revendication 1, caractérisé en ce qu'on soumet le matériau soumis à un éclairement énergétique en forme d'image à un réchauffement ultérieur à une température dans le domaine de 60 à 140°C.

6. Procédé selon la revendication 1 ou 5, caractérisé en ce qu'on soumet le matériau à un réchauffement ultérieur pendant un laps de temps de 10 à 120 secondes.

7. Procédé selon la revendication 1 ou 2, caractérisé en ce qu'on dose le réchauffement ultérieur et l'exposition ultérieure de façon à durcir complètement les endroits contenant une image et à laisser complètement soluble dans le révélateur les endroits exempts d'images.

8. Procédé selon la revendication 1, caractérisé en ce qu'on procède d'abord à l'éclairement énergétique en forme d'image du matériau d'enregistrement photopolymérisable, puis on l'expose sans original, puis on le chauffe.

9. Procédé selon la revendication 1, caractérisé en ce qu'on ajoute à la couche photopolymérisable un colorant photoréductible à titre de coinitiateur.

10. Procédé selon la revendication 1 ou 9, caractérisé en ce que le composé polymérisable par voie radicalaire contient au moins un groupe photo-oxydable.

11. Procédé selon la revendication 9, caractérisé en ce qu'on ajoute à la couche photopolymérisable en outre un composé trihalogénométhyle séparable par rayonnement.

12. Procédé selon la revendication 1, caractérisé en ce que le métallocène est un titanocène ou un zirconocène.

13. Procédé selon la revendication 9, caractérisé en ce que le colorant photoréductible est un colorant de xanthène, un colorant de thiazine, un colorant de pyronine, un colorant de porphyrine ou un colorant d'acridine.
